Europäisches Patentamt

(19) European Patent Office

Office européen des brevets

(11) Publication number : **0 293 823 B1**

(12) **EUROPEAN PATENT SPECIFICATION**

(45) Date of publication of patent specification :
19.04.95 Bulletin 95/16

(51) Int. Cl.⁶ : **G03F 7/20, G03B 41/00**

(21) Application number : **88108673.0**

(22) Date of filing : **12.06.85**

(54) **Deep-UV lithography.**

(30) Priority : **21.06.84 US 623247**

(43) Date of publication of application :
**07.12.88 Bulletin 88/49**

(45) Publication of the grant of the patent :
**19.04.95 Bulletin 95/16**

(84) Designated Contracting States :
**DE FR GB IT NL**

(56) References cited :
**EP-A- 0 066 053
EP-A- 0 105 214
EP-A- 0 128 993
EP-A- 0 154 866
US-A- 3 573 849
US-A- 3 902 036
US-A- 4 063 064**

(60) Publication number of the earlier application in
accordance with Art. 76 EPC : **0 183 827**

(73) Proprietor : **AT & T Corp.
32 Avenue of the Americas
New York, NY 10013-2412 (US)**

(72) Inventor : **Bruning, John Henry
Carroll Drive
Brookside New Jersey 07926 (US)**

(74) Representative : **Johnston, Kenneth Graham et
al
AT&T (UK) LTD.
AT&T Intellectual Property Division
5 Mornington Road
Woodford Green Essex, IG8 OTU (GB)**

## Description

## Background of the Invention

This invention relates to optical lithography and, more particularly, to apparatus and methods for achieving short-wavelength optical lithography adapted for fabricating high-quality fine-line semiconductor devices.

It is known that the resolution limit ($L_{min}$) for equal lines and spaces in an optical imaging system can be expressed as

$$L_{min} = K\lambda/NA \quad (1)$$

where K is a constant whose value is typically between 0.4 and 1.0 depending on processing and illumination conditions and resist characteristics, $\lambda$ is the wavelength of the exposing radiation and NA is the numerical aperture of the projection optics.

It is apparent from (1) that the minimum printable feature can be reduced by decreasing $\lambda$ or by increasing NA. But, since the depth of focus of the system varies inversely as $(NA)^2$, it is usually preferable in a practical high-resolution system to achieve the desired $L_{min}$ by reducing $\lambda$ rather than increasing NA.

U.S.-A-3 573 849 discloses apparatus for generating patterns from stored information. A photosensitive medium is scanned by a light beam reflected by a rotating mirror assembly. Orientation is not maintained during motion of the equipment but only provides adjustment at the end of motion.

EP-A-0 128 993, which belongs to the state of the art pursuant to Article 54(3) & (4) EPC, describes a source of radiation spaced from an object to be irradiated, a system for maintaining alignment of the radiation during any relative movements of the source and object, and a lens assembly within the system.

The present invention is directed to a novel short-wavelength lithograph system.

In accordance with one aspect of the invention there is provided a radiation system as claimed in claim 1.

In accordance with another aspect of the invention there is provided a method of focussing radiation as claimed in claim 8.

A lithograph system according to the invention includes a narrow-bandwidth tunable laser operating at a wavelength in the deep-UV range. A monochromatic all-fused-silica lens assembly is utilized to direct the output of the laser to successive portions of the surface of a resist-coated wafer mounted on a movable support, eg. a known "stepping table".

The combination of a narrow-bandwidth laser and a monochromatic lens assembly in accordance with the invention makes it possible to quickly and easily accomplish focus tracking in the system. This is done by directing the output of a laser onto the surface of a workpiece via a projection lens and controlling the wavelength of the laser to maintain the focal length of the lens equal to the lens-to-workpiece surface spacing.

Other features of the system are described hereinafter.

## Brief Description of the Drawing

FIGS. 1 and 2 taken together schematically depict an apparatus in accordance with the invention for achieving short-wavelength optical lithography; and

FIG. 3 shows in more detail a par implementation of a portion of FIG. 1.

## Detailed Description

The invention is described in connection with a known type of "step-and-repeat" lithographic system.

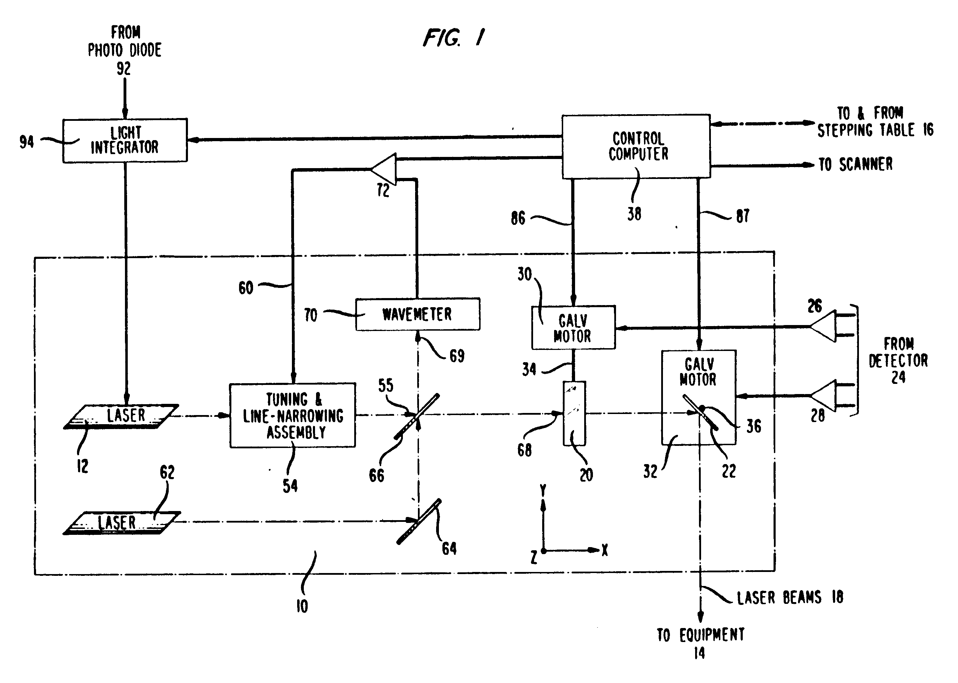

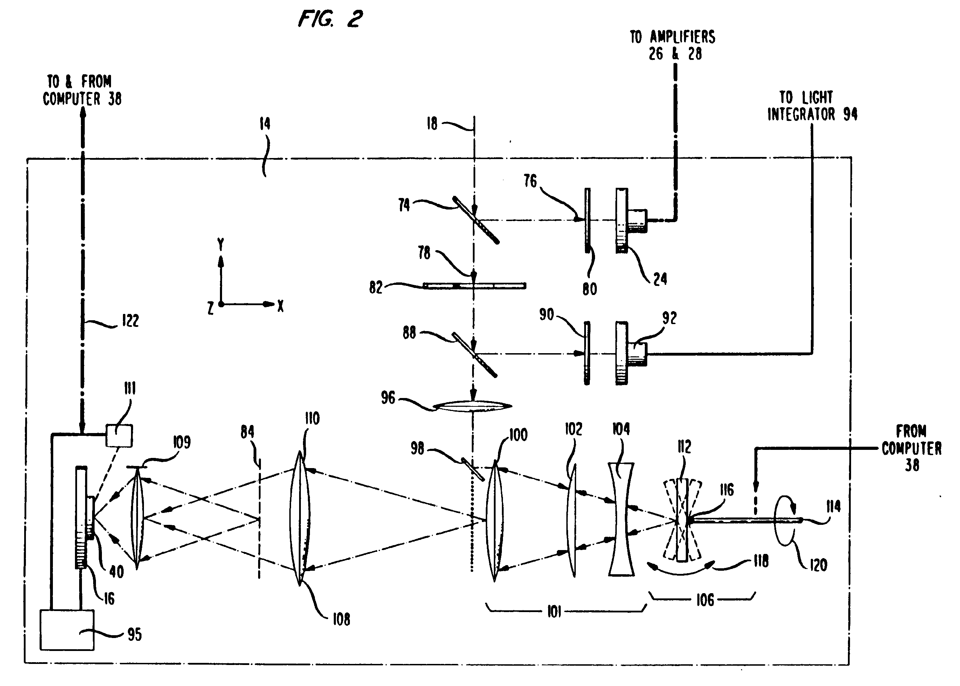

In accordance with one feature of the invention, a laser illumination source is physically separated from the movable table portion of the system. Thus, for example, the equipment 10 including laser 12 shown in FIG. 1 is advantageously located at a site removed from the equipment 14 including stepping table 16 shown in FIG. 2. In this arrangement, the laser beam provided by the equipment 10 is propagated through air or controlled space to the equipment 14, as indicated by arrow 18 in FIG. 1. (Actually, as will be clear later below, two coaxially disposed laser beams are transmitted from the equipment 10 in the direction of the arrow 18. One beam constitutes the exposing radiation. The other beam is utilized only for alignment control purposes.)

There are several reasons for physically separating the aforementioned equipments 10 and 14. In some cases, for example, the laser 12 shown in FIG. 1 includes a toxic constituent which for safety considerations should be located at a site remote from operating personnel.

In operation, the stepping table moves sucessive portions of a resist coated semiconductor wafer 40 into the path of the illuminating radiation. In the past, after each indexing of the table, a delay was necessary to allow damping out of vibrations caused by the table movements before the illuminating beam was turned on. This is time consuming.

In accordance with a feature of the invention, instrumentalities are provided in the equipments 10 and 14 for instantaneously moving the laser beams in conformity with the vibrations in the table 16 for maintaining the laser beams 18 aligned relative to the table. Thus, after each indexing of the table, the beam can be more quickly turned on. Illustratively, these instrumentalities include standard driven galvanometer mirrors 20 and 22 in the equipment 10 and a conventional quadrant photodetector or position-sensitive photodetector 24 mounted on the table 16. Electrical signals provided by the array 24 are applied to differential amplifiers 26 and 28 in feedback loops that respectively control galvanometer motors 30 and 32. The motor 30 is mechanically coupled to the mirror 20 via a Y-axis-parallel shaft 34, and the motor 32 is coupled to the mirror 22 via a Z-axis-parallel shaft 36. By selective rotation of the mirrors 20 and 22, the orientation of the laser beams 18 emanating from the equipment 10 is varied in a controlled manner to compensate for vibratory movement of the table 16.

Under quiescent conditions, the desired orientation of the laser beams 18 relative to the table 16 is established by steady-state signals applied to the galvanometer motors 30 and 32 from a control computer 38. The additional variable signals supplied by the differential amplifiers 26 and 28 to the motors 30 and 32 are superimposed on the steady-state signals supplied by the computer. This process is described further hereinafter.

Each of the lenses included in the equipment 14 of FIG. 2 is made only of fused silica. Fused silica is a highly stable material that is highly transparent to short-wavelength light. Moreover, fused silica can be fabricated with good precision to form specified lens designs. Despite these apparent advantages, applicant is the first to have proposed the use of a single optical material (fused silica) to make a high-quality lens assembly for short-wavelength (for example, deep-UV) optical lithography based on laser illumination. Heretofore, it has been customary to fabricate lenses utilizing multiple materials to correct for chromatic aberrations.

Once he designed an all-fused-silica lens assembly, applicant recognized that a laser source to be combined with the assembly must as a practical matter have an extremely narrow bandwidth if chromatic aberrations in the single-optical-material assembly were to be avoided. Since chromatic aberrations are unavoidable with a single-optical-material design, if the laser source bandwidth is not suitably narrow, the projected image on the laser-beam-illuminated wafer 40 (FIG. 2) would be unacceptably blurred.

But applicant found that all suitable short-wavelength laser sources of adequate power were pulsed lasers that inherently exhibit excessively broad bandwidths. At that point, the obvious thing to have done, as other workers in the art have, would have been to redesign the lens assembly to be free of chromatic aberrations with the available source bandwidths. But this would have entailed employing optical materials other than only fused silica. Instead, applicant embarked on the unobvious course of retaining an all-fused-silica lens design and redesigning the laser source to exhibit an appropriately narrow bandwidth. This unique approach allows the realization of a superior lens design and, moreover, is the basis for achieving electronic focus tracking as well as for achieving electronic tuning of the laser source. Such tuning allows the source to be matched to the operating characteristics of the lens assembly, as will be specified in detail later below.

Illustratively, the laser 12 included in the equipments 10 of FIG. 1 comprises an excimer laser. This category of lasers is capable of UV emission at wavelengths from, for example, below 4000 Å to below 2000 Å.

Excimer lasers and their application to lithography are described in a number of publications. These include: "Laser Projection Printing" by G. M. Dubroeucq et al, Proceedings of Microcircuit Engineering Conference, Aachen, Germany, September 1979, pages 328-337; "Applications of Excimer Lasers in Microelectronics" by T. McGrath, Solid State Technology, December 1983, pages 165-169; "Deep UV Exposure of $Ag_2Se/GeSe_2$ Utilizing an Excimer Laser" by K. J. Polasko et al, IEEE Electron Device Letters, Vol. EDL-5, No. 1, January 1984, pages 24-26; and "Excimer Laser Projection Lithography" by K. Jain et al, Applied Optics, Vol. 23, No. 5, March 1, 1984, pages 648-650.

By way of example, the laser 12 of FIG. 1 comprises a pulsed KrF gas excimer laser designed to operate at a nominal center wavelength of 2484 Å. (The fluorine constituent in KrF is highly toxic.) Illustratively, the pulse repetition rate of the laser 12 is selected to be approximately 1000 pulses per second.

Inherently, the KrF excimer laser 12 (FIG. 1) has a spectral bandwidth at the half-power point of approximately 10 Å. But, recognizing that an all-fused-silica lens assembly for high-resolution lithography requires a source bandwidth of less than about 0.1 Å to be free of chromatic aberrations, applicant combined a bandwidth-narrowing assembly with the laser 12 to achieve an output at 2484 Å characterized by a half-power-point bandwidth of only approximately 0.05 Å. At a repetition rate of 1000 pulses per second, the power of each such pulse is about 5 millijoules, which characteristics provide an adequate basis for uniform high-resolution high-throughput lithography.

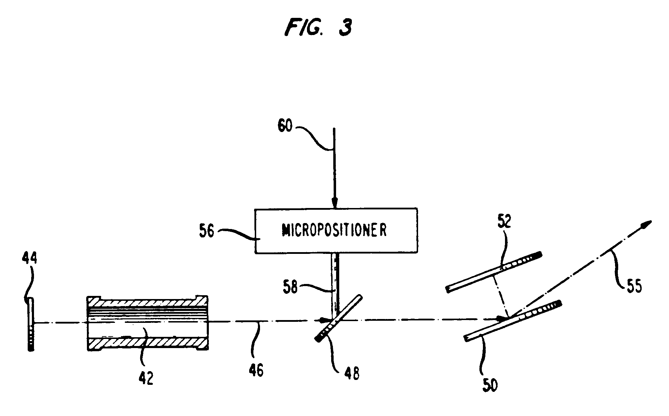

Various techniques are available for narrowing the inherent bandwidth of the laser 12. One suitable assembly for doing this is shown in FIG. 3 (the figure also showing portions 42 and 44 of the laser). Beam 46 emanating from the laser propagates through a standard low-finesse etalon 48 and impinges upon a conventional grazing-incidence grating 50 which is spaced apart from a facing high-reflectivity mirror 52. Illustratively, the grating 50 has 3000-to-4000 grooves per millimeter. The elements 48, 50 and 52 constitute both a tuning and a bandwidth narrowing assembly. This assembly is shown in FIG. 1 and identified therein by reference numeral 54 ("bandwidth narrowing" is also referred to in the art as "line-narrowing").

The desired narrow-bandwidth output emanates from assembly 54 and propagates in the direction indicated by arrow 55 in FIG. 3. The arrow 55 is also shown in FIG. 1 wherein it is oriented parallel to the X axis.

The assembly 54 also provides a means for establishing the center wavelength of the laser output 55 at a predetermined value and thereafter precisely maintaining the wavelength at that value (or purposely moving the wavelength off that value to accomplish electronic focus tracking). This is accomplished by rotating any one or combination of the elements 48, 50 and 52 about an axis perpendicular to the plane of the paper on which FIG. 3 is drawn. For coarse tuning, rotating the mirror 52 and/or the grating 50 is satisfactory. For fine tuning, rotating only the etalon 48 is effective. In practice, it is usually advantageous to initially establish the predetermined center wavelength by rotating one or both of the elements 50 and 52. Thereafter, the laser can be maintained at that wavelength or fine-tuned therefrom by selectively controlling the orientation of only the etalon 48.

As schematically indicated in FIG. 3, a micropositioner 56 is connected via a mechanical coupler 58 to the etalon 48. In response to signals applied to the micropositioner 56 on line 60, the orientation of the etalon is thereby controlled to maintain the wavelength of the laser beam 55 at a predetermined value or to move the wavelength off that value by a specified amount to accomplish electronic focus tracking. The manner in which the micropositioner 56 is so controlled will be described in detail later below.

Various instrumentalities are known in the art for tuning and line-narrowing the output of wavelength laser as is done by assembly 54. In this connection, see, for example: "Injection-Locked, Narrow-Band KrF Discharge Laser Using an Unstable Resonator Cavity" by J. Goldhar et al, Optics Letters, Vol. 1, No. 6, December 1977, pp. 199-201; "Operating and Beam Characteristics, Including Spectral Narrowing, of a TEA Rare-Gas Halide Excimer Laser" by T. J. McKee et al, IEEE Journal of Quantum Electronics, Vol. QE-15, No. 5, May 1979, pp. 332-334; "Grazing Angle Tuner for CW Lasers" by K. R. German, Applied Optics, Vol. 20, No. 18, September 15, 1981, pp. 3168-3171; and "A Simple Tunable KrF Laser System with Narrow Bandwidth and Diffraction-Limited Divergence" by R. G. Caro et al, Journal Physics D: Applied Physics, 15, 1982, pp. 767-773.

The aforedescribed feedback loops for controlling the galvanometer motors 30 and 32 (FIG. 1) require continuous electrical input signals. But the pulsed laser 12 is not capable of providing such signals via the detector 24 (FIG. 2). Hence, a continuous-wave (CW) laser 62 (for example, a standard helium-neon laser operating at 6328 Å) is also included in the equipment 10. The laser 62 is designed to provide a continuous reference beam that is coaxial with the aforespecified beam at 2484 Å. In turn, the beam at 6328 Å is converted by the detector 24 into continuous electrical signals that are applied to the feedback loops that respectively control the galvanometer motors 30 and 32.

Whenever the detector 24 senses that the reference beam at 6328 Å is off-center relative to its prescribed alignment with the detector 24, correction signals are applied to the motor 30 and/or to the motor 32 to re-establish the prescribed alignment. And, since the beams at 6328 Å and 2484 Å are propagated coaxially in the equipment 10, these correction signals are effective to re-establish the prescribed alignment of the exposing beam at 2484 Å.

The output of the CW laser 62 (FIG. 1) is directed via a high-reflectivity mirror 64 to a dichroic mirror 66. The mirror 66 is designed to reflect the incident beam at 6328 Å to the right along an X-direction path indicated by arrow 68. The mirror 66 is also designed to transmit most of the incident beam at 2484 Å emanating from the assembly 54 along the same X-direction path. Thus, the arrow 68 indicates the path along which the CW beam at 6328 Å and the pulsed beam at 2484 Å propagate coaxially to successively impinge upon the galvanometer mirrors 20 and 22. After reflection from the mirrors 20 and 22, the coaxial beams are propagated from the equipment 10. These coaxial beams constitute the previously specified beams 18.

A small portion (for example, about one percent) of the beam at 2484 Å emanating from the assembly 54 of FIG. 1 is reflected upward by the mirror 66 along a Y-direction path indicated by arrow 69 to a wavemeter 70. In response thereto, the wavemeter 70 provides an electrical signal to one input of a differential amplifier 72. The other input to the amplifier 72 is supplied by the control computer 38. in that way, the output of the amplifier 72 applied to the lead 60 is effective to maintain the output of the assembly 54 at a predetermined center wavelength specified by the computer 38. Or, as will be described in more detail later below, the signal applied to the amplifier 72 by the computer 38 can also be utilized to purposely change the center wavelength to achieve electronic focus tracking.

Further, the aforespecified ability of the computer 38 (FIG. 1) to easily control or adjust the center wavelength of the beam emanating from the assembly 54 simplifies the overall design and fabrication of the equipment described herein. This is so because in practice one can rarely make an all-fused-silica lens assembly precisely to a specified prescription. Normally, one would have to install the fabricated lens assembly in the equipment, test the assembly at a prespecified center frequency, and then take the assembly apart to make adjustments therein by further machining, polishing, etc.

Subsequently, re-installation of the lens assembly and further testing in the equipment would be done, and so forth in an interactive fashion until a near-optimal match between the lens assembly and the center wavelength was obtained. Such mechanical tuning or matching of the lens assembly to a fixed prespecified center wavelength is obviously time-consuming and expensive.

By contrast, in applicant's unique design, it is often possible, after initially installing the all-fused-silica lens assembly in the herein-described equipment, to achieve a near-ideal adjustment of the equipment without removing the lens assembly. This is done by leaving the installed assembly intact and adjusting the center wavelength of the exposing beam, under control of the computer 38, to obtain a near-optimal match between the operating characteristics of the lens assembly as initially fabricated and the operating wavelength of the equipment. Such electronic, rather than mechanical, adjustment of the equipment is manifestly advantageous.

The laser beams at 2484 Å and 6328 Å that emanate from the equipment 10 in the direction of arrow 18 are directed at the equipment 14 shown in FIG. 2. In particular, these beams are directed at a mirror 74 in the equipment 14. The mirror 74 is designed to be highly reflective at 6328 Å and highly transmissive at 2484 Å As a result, most of the 6328 Å beam is directed to the right in the direction of arrow 76 and most of the 2484 Å beam is directed downward in the direction of arrow 78.

The 6328 Å beam propagated in the direction of the arrow 76 in FIG. 2 passes through a filter 80. The filter 80 is designed to pass the 6328 Å beam but to block any portion of the 2484 Å beam that was reflected by the mirror 74 in the direction of the arrow 76. Accordingly, only the CW beam at 6328 Å impinges upon the detector 24. In turn, as described earlier above, the detector 24 provides continuous electrical signals in the feedback loops shown in FIG. 1 to control the operation of the galvanometer motors 30 and 32. In that way, the orientation of the 6328 Å beam 76 relative to the table 16, and thus also the orientation of the coaxially disposed 2484 Å exposing beam 78, are maintained fixed even during vibratory motion of the table 14.

The 2484 Å beam propagated downward in FIG. 2 in the direction of the arrow 78 is directed at an adjustable field stop or aperture 82. Illustratively, the diameter of the beam at the stop 82 is designed to be larger than the diameter of the opening in the stop.

In practice, the equal-intensity contour lines of the 2484 Å beam transmitted through the stop 82 of FIG. 2 are not symmetrically disposed with respect to the opening in the stop. Moreover, this asymmetry tends to vary from pulse to pulse. If not compensated for, these factors can result in unsatisfactory illumination uniformity and consequent poor linewidth control at the surface of the wafer 40.

In accordance with a feature of the invention, the slightly oversize beam directed at the stop 82 is dithered or moved systematically by small amounts $\Delta X$ and $\Delta Z$. For an exposure that comprises, for example, several hundred successive laser pulses, such movement is effective to accomplish area averaging of the pulses transmitted through the stop 82. In turn, this results in better illumination uniformity at the surface of the wafer 40.

Movement of the 2484 Å beam 78 directed at the stop 82 (FIG. 2) to carry out area averaging is controlled by the computer 38 (FIG. 1). Signals applied by the computer 38 via leads 86 and 87 to the galvanometer motors 30 and 32, respectively, are effective to implement the aforementioned $\Delta Z$ and $\Delta X$ movements of the beam across the aperture in the stop 82.

The 2484 Å beam 78 that passes through the stop 82 impinges upon a mirror 88 shown in FIG. 2. This mirror is designed to reflect a relatively small amount (for example about one percent) of the incident beam. In turn, the reflected portion is directed through a filter 90 to a photodiode 92. The filter 90 is designed to pass light at 2484 Å but to block light at 6328 Å. In that way, any 6328 Å component in the beam transmitted by the stop 82 is prevented from impinging on the photodiode 92.

The photodiode 92 of FIG. 2 constitutes part of a dose control and laser trigger arrangement. The photodiode 92 samples a portion of each 2484 Å pulse and, in response thereto, generates an electrical signal that is applied to a light integrator 94 (FIG. 1). The control computer 38 supplies a second input signal (a dose control signal) to the light integrator 94. In turn, the output of the integrator 94 is applied to the laser 12 as a trigger signal therefor.

The operation of the dose control and laser trigger arrangement is as follows. Under computer control, the stepping table 16 is pulsed by a micropositioner 95 to bring a chip site on the resist-coated wafer 40 into position for exposure to the pattern contained on the reticle 84. (Illustratively, the reticle is assumed to contain a single chip pattern thereon.) The computer 38 then activates the integrator 94 to trigger the laser 12 to start emitting pulses at 2484 Å. A portion of each pulse is sampled by the photodiode 92 and a signal representative thereof is applied to the integrator 94. When the integrator 94 detects that the prescribed dose set by the computer 38 has been attained, the laser 12 is signaled to cease emitting pulses. Subsequently, the table 16 is moved to position another chip site on the wafer 40 in position for the next exposure.

Exposure is accomplished by projection of illumination through a condenser lens 110, through a reticle 84 containing the pattern to be imaged on the wafer 40, and through a projection lens 108. The provision of a virtual source of illumination for the lens 110 is now described.

As indicated in FIG. 2, the 2484 Å beam 78 that is transmitted through the mirror 88 is directed toward a collimating lens 96. The lens 96 serves to focus the beam to a small spot and to direct it at a mirror or prism element 98. The small spot comprises a first virtual source of illumination. The element 98 is designed to deflect the beam into the edge of the field of a scanning lens assembly 101 represented here by field lens 100 and additional lens elements 102 and 104. In turn, the beam is reflected by a scanning mirror assembly 106 back into the scanning lens assembly 101.

To achieve adequate illumination of the entrance pupil of the projection lens 108 and hence proper imaging characteristics on the wafer 40, it is advantageous to illuminate about 50-to-75 percent of the diameter of the entrance pupil of the lens 108. Illustratively, the entrance pupil of the lens 108, as defined by an aperture stop 109 (shown schematically in FIG. 2), is approximately 100 millimeters in diameter. It is apparent, therefore, that simply relaying the small first virtual source to the lens 108 will not in practice provide adequate illumination of the entrance pupil of the lens 108.

In accordance with one aspect of the invention, the effective size of the virtual source that is actually relayed to the projection lens 108 is substantially increased in size over that of the first virtual source produced by the lens 96. This is done by means of the scanning lens assembly 101 and the scanning mirror assembly 106. By means of these assemblies, the operation of which is described hereinafter, both the size and shape of the effective virtual source can be selectively varied under control of signals applied to the assembly 106 from the computer 38. Significantly, in the course of making such variations, no laser light at 2484 Å is wasted in the depicted equipment. Hence, all available exposing light is delivered to the surface of the wafer 40 even as changes are made in the size and shape of the illumination relayed to the entrance pupil of the projection lens 108.

The ability to change both the size and shape of the illuminated portion of the entrance pupil of the projection lens 108 can be significant in that it allows, for example, tailoring the illumination to optimize resolution of certain critical features on the wafer 40 and to take maximum advantage of any nonlinearities in the characteristics of the resist layer on the wafer 40.

The scanning mirror assembly 106 schematically depicted in FIG. 2 comprises a mirror 112 and two independently rotatable shafts 114 and 116. The shaft 114 is oriented parallel to the X axis, whereas the shaft 116 is oriented perpendicular to the X axis. Rotation back and forth of the shaft 116 causes the mirror 112 to rock back and forth, as indicated by double-headed arrow 118. At the same time that rocking occurs, the shaft 114 is turning, as indicated by arrow 120. In other words, as the mirror rocks in response to rotation of the shaft 116, the rocking mirror is independently rotated by the shaft 114. As a consequence, a relatively large area A in a Y-Z plane immediately to the left of the lens 100 can be substantially filled with the successive pulses supplied by the laser 12 of FIG. 1 to form a large-area virtual source. Illustratively, several hundred successive pulses are supplied by the laser 12 during each interval in which a chip site on the wafer 40 is being exposed.

The size of the aforespecified large-area virtual source can be changed by varying the extent to which the mirror 112 is rocked by the shaft 116. Additionally, the shape of the virtual source can be changed by varying the speed of rotation of the shaft 114 while the mirror 112 is being rocked.

Light emanating from the relatively large-area virtual source formed to the left of the lens 100 (FIG. 2) is directed by the relay lens 110 to illuminate the pattern contained on the reticle 84. In turn, light propagated through the reticle 84 is imaged by the lens 109 onto a chip site on the surface of the wafer 40. Illustratively, the lens 109 forms a reduced (for example 5-to-1 reduced) version of the reticle pattern on the wafer surface.

In a standard exposure system, conventional focus tracking is accomplished by mechanically changing the projection lens-to-wafer distance. Typically, this is done either by moving the optical column of the system or by moving the wafer. In either case, the adjustment is time-consuming and, moreover, may cause undesirable mechanical resonances in the system.

In accordance with one aspect of the present invention, focus tracking is carried out quickly in a nonmechanical manner. The ability to do so stems from the use of lenses made from a single optical material. Such lenses, unlike those corrected for chromatic aberrations, exhibit an approximately linear relationship between wavelength and focal distance. Hence, by electronically changing the wavelength of the laser 12 (FIG. 1), the focal plane of the projection lens 108 (FIG. 2) is also changed.

The operation of the focus tracking arrangement is as follows. First, a standard focus sensor 111 detects whether or not the distance between the projection lens 108 and the surface of the wafer 40 has changed from a prespecified value. Assume, for example, that that distance has changed (decreased) by one micron, due, for example, to warpage in the wafer 40. A signal representative of the change is then sent to the computer 38 via lead 122. In response thereto, the computer applies a corresponding correction signal to the differential amplifier 72 (FIG. 1) included in the aforedescribed frequency control loop. In turn, a signal is applied by the amplifier 72 to the tuning and line-narrowing assembly 54 to increase the center wavelength of the pulses emanating from the assembly 54. In one illustrative case, the center wavelength was increased by 0.1 Å. This was sufficient to decrease the focal distance of the lens 108 by one micron, thereby to compensate exactly for the assumed one-micron decrease in the lens-to-wafer spacing.

**Claims**

1. A radiation system comprising a source of narrow bandwidth radiation in a first part of the system, an apparatus for supporting an object in a second part of the system, said object to be irradiated by the radiation, and means for directing at least a portion of the radiation from the first part to the object in the second part, the first and second parts being spaced apart and movable relative to one another, CHARACTERISED IN THAT a lens assembly (101,108,110) made of fused silica is disposed in the path of the radiation, and in that the directing means comprises detection means (24) responsive to deviations of the radiation from a desired path in the second part, and radiation adjustment means (30,32) (20,22) responsive to the detection means and serving to alter the radiation path to maintain alignment with the said desired path even during relative movement of the two parts.

2. A system according to claim 1, wherein the supporting apparatus includes a stepping table (16).

3. A system according to claim 1, wherein said source includes a laser (12).

4. A system according to claim 3, wherein said laser is capable of emitting deep U.V. radiation.

5. A system according to claim 4, wherein the laser is an excimer laser or a KrF excimer laser.

6. A system according to any one of the preceding claims, wherein the directing means includes a projection lens (108) capable of optical communication with the source and the object.

7. A system according to claim 1, wherein the directing means includes a mirror (20 or 22) capable of optical communication with the source and the object, and wherein the aligning means includes orienting means (30 or 32) for rotating the mirror relative to the source in response to a deviation from the desired alignment.

8. A method of irradiating an object, comprising the steps of providing a source of narrow bandwidth radiation in a first part of the system, mounting the object on an apparatus in a second part of the system, and directing at least a portion of the radiation from the first part to the object in the second part, the first and second parts being spaced apart and movable relative to one another, CHARACTERISED IN THAT a lens assembly (101,106,108,110) made of fused silica is disposed in the path of the radiation, and in that the step of directing comprises detecting deviations of the radiation from a desired path in the second part, and adjusting the radiation as a result of the detection, so as to alter the radiation path and maintain alignment with the desired path even during relative movement of the two parts.

9. A method according to claim 8, wherein the radiation is deep U.V. radiation derived from a laser.

10. A method according to claim 8 or 9, wherein the directing step is achieved by directing the radiation to a mirror in the first part and rotating the mirror in response to a deviation from the desired path.

**Patentansprüche**

1. Strahlungssystem mit einer Quelle einer Strahlung mit schmaler Bandbreite in einem ersten Teil des Systems, einer Einrichtung zum Halten eines Objektes, das von der Strahlung bestrahlt werden soll, in einem zweiten Teil des Systems und mit einer Einrichtung zum Richten wenigstens eines Anteils der Strahlung vom ersten Teil zum Objekt im zweiten Teil, wobei der erste und der zweite Teil in einem Abstand voneinander angeordnet und relativ zueinander bewegbar sind, dadurch gekennzeichnet, daß eine Linsen-Baugruppe (101, 108, 110) aus geschmolzenem Siliciumdioxid bzw. Quarzglas im Strahlungsweg angeordnet ist, und daß die Richteinrichtung Erfassungsmittel (24), die auf Abweichungen der Strahlung von einem erwünschten Weg im zweiten Teil ansprechen, und Strahlungseinstellmittel (30, 32) (20, 22) aufweisen, die auf die Erfassungsmittel ansprechen und dazu dienen, den Strahlungsweg zu ändern, um die Ausrichtung zu dem erwünschtem Weg sogar während einer Relativbewegung der zwei Teile zu halten.

2. System nach Anspruch 1, bei dem die Halteeinrichtung einen Tisch (16) mit Schrittantrieb aufweist.

3. System nach Anspruch 1, bei dem die Quelle einen Laser (12) aufweist.

4. System nach Anspruch 3, bei dem der Laser Strahlung im fernen UV-Bereich ausstrahlen kann.

5. System nach Anspruch 4, bei dem der Laser ein Excimerlaser oder ein KrF-Excimerlaser ist.

6. System nach einem der vorstehenden Ansprüche, bei dem die Richteinrichtung eine Projektionslinse (108) aufweist, die mit der Quelle und dem Objekt in optischer Verbindung stehen kann.

7. System nach Anspruch 1, bei dem die Richteinrichtung einen Spiegel (20 oder 22) aufweist, der mit der Quelle und dem Objekt in optischer Verbindung stehen kann, und bei dem die Ausrichtmittel Orientierungseinrichtungen (30 oder 32) enthalten, um den Spiegel unter Ansprechen auf eine Abweichung von der erwünschten Ausrichtung relativ zur Quelle zu drehen.

8. Verfahren zum Bestrahlen eines Objektes, mit den Schritten des Bereitstellens einer Quelle einer Strahlung mit schmaler Bandbreite in einem ersten Teil des Systems, des Befestigens des Objektes an einer Einrichtung in einem zweiten Teil des Systems sowie des Richtens wenigstens eines Anteils der Strahlung vom ersten Teil zum Objekt im zweiten Teil, wobei der erste und der zweite Teil in einem Abstand voneinander angeordnet und relativ zueinander bewegbar sind, dadurch gekennzeichnet, daß eine Linsen-Baugruppe (101, 106, 108, 110) aus geschmolzenem Siliciumdioxid bzw. Quarzglas im Strahlungsweg angeordnet ist, und daß der Schritt des Richtens das Erfassen von Abweichungen der Strahlung von einem erwünschten Weg im zweiten Teil und das Einstellen der Strahlung als ein Ergebnis der Erfassung beinhaltet, um den Strahlungsweg zu ändern und die Ausrichtung zu dem erwünschten Weg sogar während einer Relativbewegung der zwei Teile zu halten.

9. Verfahren nach Anspruch 8, bei dem die Strahlung von einem Laser erhaltene Strahlung im fernen UV-Bereich ist.

10. Verfahren nach Anspruch 8 oder 9, bei dem der Schritt des Richtens durch Richten der Strahlung zu einem Spiegel im ersten Teil und Drehen des Spiegels unter Ansprechen auf eine Abweichung vom erwünschten Weg ausgeführt wird.

## Revendications

1. Système de rayonnement comprenant une source de rayonnement de largeur de bande étroite dans une première partie du système, un appareil pour supporter un objet dans une seconde partie du système, ledit objet devant être traversé par le rayonnement, et un moyen pour diriger au moins une partie du rayonnement provenant de la première partie vers l'objet dans la seconde partie, les première et seconde parties étant espacées et mobiles l'une par rapport à l'autre, CARACTERISE EN CE QU'un ensemble de lentilles (101,108,110) réalisé en verre de silice est disposé dans la trajectoire du rayonnement, et en ce que le moyen directeur comprend un moyen de détection (24) sensible à des écarts du rayonnement par rapport à une trajectoire désirée dans la seconde partie, et un moyen de réglage de rayonnement (30,32) (20,22) sensible au moyen de détection et servant à modifier la trajectoire de rayonnement pour maintenir l'alignement avec ladite trajectoire désirée même durant un mouvement relatif des deux parties.

2. Système selon la revendication 1, dans lequel l'appareil de soutien comporte une table pas-à-pas (16).

3. Système selon la revendication 1, dans lequel ladite source comporte un laser (12).

4. Système selon la revendication 3, dans lequel ledit laser est capable d'émettre un rayonnement ultraviolet lointain.

5. Système selon la revendication 4, dans lequel le laser est un laser excimère ou un laser excimère KrF.

6. Système selon l'une quelconque des revendications précédentes, dans lequel le moyen directeur comporte une lentille de projection (108) capable de communication optique avec la source et l'objet.

7. Système selon la revendication 1, dans lequel le moyen directeur comporte un miroir (20 ou 22) capable de communication optique avec la source et l'objet, et dans lequel le moyen d'alignement comporte un moyen d'orientation (30 ou 32) pour tourner le miroir relativement à la source en réponse à un écart par rapport à l'alignement désiré.

8. Procédé de rayonnement d'un objet, comprenant les étapes de fourniture d'une source de largeur de bande étroite dans une première partie du système, montage de l'objet sur un appareil dans une seconde partie du système, et direction d'au moins une partie du rayonnement depuis la première partie du système vers l'objet dans la seconde partie, les première et seconde parties étant espacées et mobiles l'une par rapport à l'autre, CARACTERISE EN CE QU'un ensemble de lentilles (101,106,108,110) réalisé en verre de silice est disposé dans la trajectoire du rayonnement, et en ce que l'étape de direction comprend la détection d'écarts du rayonnement par rapport à une trajectoire désirée dans la seconde partie, et le réglage du rayonnement à la suite de la détection, de manière à modifier la trajectoire de rayonnement et maintenir l'alignement avec la trajectoire désirée même durant le mouvement relatif des deux parties.

9. Procédé selon la revendication 8, dans lequel le rayonnement est un rayonnement ultraviolet lointain provenant d'un laser.

10. Procédé selon la revendication 8 ou 9, dans lequel l'étape de direction est réalisée en dirigeant le rayonnement vers un miroir dans la première partie et en tournant le miroir en réponse à un écart par rapport à la trajectoire désirée.

FIG. 1

FIG. 2

FIG. 3